# EUROPÄISCHE PATENTSCHRIFT

(11) **EP 1 668 465 B1**
(45) Veröffentlichungstag und Bekanntmachung des Hinweises auf die Patenterteilung: **09.05.2007**
(21) Anmeldenummer: 04787125.6
(22) Anmeldetag: 10.09.2004
(51) Int. Cl.: G06F 1/10

(54) **VORRICHTUNG ZUR VERWENDUNG BEI DER SYNCHRONISATION VON TAKTSIGNALEN, SOWIE TAKTSIGNAL-SYNCHRONISATIONSVERFAHREN**
DEVICE USED FOR THE SYNCHRONIZATION OF CLOCK SIGNALS, AND CLOCK SIGNAL SYNCHRONIZATION METHOD
DISPOSITIF UTILISÉ DANS LA SYNCHRONISATION DE SIGNAUX D' HORLOGE ET PROCÉDÉ DE SYNCHRONISATION DE SIGNAUX D' HORLOGE

(30) Priorität: 30.09.2003 DE 10345489
(43) Veröffentlichungstag der Anmeldung: 14.06.2006
(73) Patentinhaber: Infineon Technologies AG, 81669 München (DE)
(72) Erfinder: RAO, Rajashekhar, 81539 München (DE); MINZONI, Alessandro, 710075 Xi'an (CN); SAGLAM, Musa, 81549 München (DE)
(74) Vertreter: Jehle, Volker Armin
(86) Internationale Anmeldenummer: PCT/EP2004/052128
(87) Internationale Veröffentlichungsnummer: WO 2005/031548

(56) Entgegenhaltungen:
- US-A- 5 790 612
- US-A1- 2002 027 430
- US-A1- 2002 180 501
- US-B1- 6 388 482
- TAE-SUNG KIM ET AL: "A low jitter, fast locking delay locked loop using measure and control scheme" MIXED-SIGNAL DESIGN, 2001. SSMSD. 2001 SOUTHWEST SYMPOSIUM ON FEB. 25-27, 2001, PISCATAWAY, NJ, USA,IEEE, 25. Februar 2001 (2001-02-25), Seiten 45-50, XP010537951 ISBN: 0-7803-6742-1

## Beschreibung

Die Erfindung betrifft eine Vorrichtung zur Verwendung bei der Synchronisation von Taktsignalen, insbesondere eine Vorrichtung zur Verwendung bei der Synchronisation eines intern in einem Speicherchips verwendeten Taktsignals mit einem extern in den Speicherchip eingegebenen Taktsignal, sowie ein Taktsignal-Synchronisationsverfahren.

Bei Halbleiter-Bauelementen, insbesondere bei Speicherbauelementen wie - z.B. auf CMOS-Technologie beruhenden - DRAMs (DRAM = Dynamic Random Access Memory bzw. dynamischer Schreib-Lese-Speicher) werden - zur zeitlichen Koordination der Verarbeitung bzw. Weiterschaltung der Daten - sog. Taktsignale verwendet.

Bei herkömmlichen Halbleiter-Bauelementen wird dabei i.A. ein - auf einer Einzel-Leitung anliegendes - Einzel-Taktsignal eingesetzt (d.h. ein sog. "single ended"-Taktsignal).

Die Daten können dann z.B. jeweils bei der ansteigenden Taktflanke des Einzel-Taktsignals weitergeschaltet werden (oder alternativ z.B. jeweils bei der abfallenden Einzel-Taktsignal-Flanke).

Des weiteren sind im Stand der Technik bereits sog. DDR-Bauelemente, insbesondere DDR-DRAMs bekannt (DDR-DRAM = Double Data Rate - DRAM bzw. DRAM mit doppelter Datenrate).

Bei DDR-Bauelementen werden - statt eines einzelnen, auf einer Einzel-Leitung anliegenden Taktsignals ("single ended"-Taktsignal) - zwei auf zwei getrennten Leitungen anliegende, differentielle, gegengleich-inverse Taktsignale verwendet.

Immer dann, wenn z.B. das erste Taktsignal der beiden Taktsignale von einem Zustand "logisch hoch" (z.B. einem hohen Spannungspegel) auf einen Zustand "logisch niedrig-(z.B. einen niedrigen Spannungspegel) wechselt, ändert das zweite Taktsignal - im wesentlichen gleichzeitig - seinen Zustand von "logisch niedrig" auf "logisch hoch" (z.B. von einem niedrigen auf einen hohen Spannungspegel).

Umgekehrt ändert immer dann, wenn das erste Taktsignal von einem Zustand "logisch niedrig" (z.B. einem niedrigen Spannungspegel) auf einen Zustand "logisch hoch" (z.B. einen hohen Spannungspegel) wechselt, das zweite Taktsignal (wiederum im wesentlichen gleichzeitig) seinen Zustand von "logisch hoch" auf "logisch niedrig" (z.B. von einem hohen auf einen niedrigen Spannungspegel).

In DDR-Bauelementen werden die Daten i.A. sowohl bei der ansteigenden Flanke des ersten Taktsignals, als auch bei der ansteigenden Flanke des zweiten Taktsignals (bzw. sowohl bei der abfallenden Flanke des ersten Taktsignals, als auch bei der abfallenden Flanke des zweiten Taktsignals) weitergeschaltet.

Damit erfolgt in einem DDR-Bauelement die Weiterschaltung der Daten häufiger bzw. schneller (insbesondere doppelt so häufig, bzw. doppelt so schnell), wie bei entsprechenden, herkömmlichen Bauelementen mit Einzel- bzw. "single ended" - Taktsignal - d.h. die Datenrate ist höher, insbesondere doppelt so hoch, wie bei entsprechenden, herkömmlichen Bauelementen.

Das - intern - im Bauelement zur zeitlichen Koordination der Verarbeitung bzw. Weiterschaltung der Daten verwendete Taktsignal ("DQS"- bzw. "data strobe"-Signal) (bzw. - bei der Verwendung differentieller, gegengleich-inverser Taktsignale - das interne Taktsignal DQS, und das zum Taktsignal DQS gegengleich-inverse Taktsignal BDQS) muß synchron zu einem extern in das Bauelement eingegebenen Taktsignal ("CLK"- bzw. "clock"-Signal) sein (bzw. synchron zu den extern in das Bauelement eingegebenen, differentiellen Taktsignalen CLK, BCLK).

Das oder die externen Taktsignale CLK, BCLK wird bzw. werden von einem entsprechenden, mit dem Bauelement verbundenen, externen Taktsignal-Geber erzeugt.

Zur Synchronisation des intern erzeugten Taktsignals DQS bzw. der intern erzeugten Taktsignale DQS, BDQS mit dem oder den externen Taktsignalen CLK, BCLK wird eine Taktsignal-Synchronisationseinrichtung, z.B. eine DLL-Schaltung (DLL = Delay-Locked-Loop) verwendet. Eine solche Schaltung ist z.B. aus der EP 964 517 bekannt.

Eine Taktsignal-Synchronisationseinrichtung kann z.B. eine erste Verzögerungseinrichtung aufweisen, in die das oder die externen Taktsignale CLK, BCLK eingegeben werden, und die das oder die eingegebenen Taktsignale CLK, BCLK - abhängig von einem von einer Phasenvergleichseinrichtung ausgegebenen Steuersignal - mit einer - durch das Steuersignal einstellbaren, variablen - Verzögerungszeit tᵥₐᵣ beaufschlagt.

Das oder die von der ersten Verzögerungseinrichtung ausgegebenen Signal(e) kann bzw. können - intern - im Bauelement zur zeitlichen Koordination der Verarbeitung bzw. Weiterschaltung der Daten verwendet werden (d.h. als - interne (s) - Taktsignal (e) DQS bzw. BDQS).

Das von der ersten Verzögerungseinrichtung ausgegebene Signal DQS wird einer zweiten Verzögerungseinrichtung zugeführt, die das eingegebene Signal DQS mit einer - festen - Verzögerungszeit t_{const} beaufschlagt, die in etwa der Summe der durch den bzw. die Receiver ("Receiver-Delay"), den jeweiligen Datenpfad ("data path delay"), und den bzw. die Off-Chip-Driver ("OCD-Delay") verursachten Signal-Verzögerungen entspricht.

Das von der zweiten Verzögerungseinrichtung ausgegebene Signal (FB-Signal bzw. "Feedback-Signal") wird der o.g. Phasenvergleichseinrichtung zugeführt, und dort die Phasenlage des FB-Signals mit derjenigen des - ebenfalls in die Phasenvergleichseinrichtung eingegebenen - CLK-Signals verglichen. Abhängig davon, ob die Phase des FB-Signal derjenigen des CLK-Signals vorauseilt, oder hinterherläuft, wird von der Phasenvergleichseinrichtung - als Steuersignal für die o.g. erste Verzögerungseinrichtung - ein Inkrement-Signal (INC-Signal), oder ein Dekrement-Signal (DEC-Signal) ausgegeben, die dazu führen, dass die durch die erste Signalverzögerungseinrichtung bewirkte Verzögerung tᵥₐᵣ des CLK-Signals - bei einem INC-Signal - erhöht, bzw. - bei einem DEC-Signal - verringert wird, sodaß schließlich das CLK- und das FB-Signal synchronisiert, d.h. die Taktsignal-Synchronisationseinrichtung "eingerastet" ("locked") ist.

Beispielsweise kann zunächst in einer ersten Phase (wenn die positive Flanke des FB-Signals der positiven Flanke des CLK-Signals (noch) hinterherläuft), von der Phasenvergleichseinrichtung ein INC-Signal erzeugt werden, das dazu führt, dass die von der ersten Signalverzögerungseinrichtung bewirkte Verzögerung tᵥₐᵣ - relativ stark - erhöht, bzw. die Phasengeschwindigkeit des FB-Signals gegenüber der Phasengeschwindigkeit des CLK-Signals - relativ stark - vergrößert wird. ("Grobeinstellung").

Wenn die positive Flanke des FB-Signals die positive Flanke des CLK-Signals "überholt", kann von der Phasenvergleichseinrichtung dann ein DEC-Signal erzeugt werden, das dazu führt, dass die von der ersten Signalverzögerungseinrichtung bewirkte Verzögerung tᵥₐᵣ (wieder) verringert, bzw. die Phasengeschwindigkeit des FB-Signals gegenüber der Phasengeschwindigkeit des CLK-Signals verkleinert wird (und zwar - zur "Feineinstellung" - nur jeweils relativ wenig).

Durch die zunächst starke, und dann relativ schwache Änderung der von der ersten Signalverzögerungseinrichtung bewirkten Verzögerungen tᵥₐᵣ bzw. Phasenverschiebungen kann - in der Regel - eine relativ schnelle Synchronisation des CLK- und FB-Signals erreicht, d.h. die Taktsignal-Synchronisationseinrichtung relativ schnell "eingerastet" werden.

Allerdings wird - aufgrund der in der DLL-Schaltung vorkommenden Signal-Verzögerungen - erste einige Takte (z.B. 4 Takte), nachdem die positive Flanke des FB-Signals die positive Flanke des CLK-Signals "überholt" hat, die oben beschriebene, durch das DEC-Signal bewirkte Verkleinerung der FB-Signal-Phasengeschwindigkeit gegenüber der CLK-Signal-Phasengeschwindigkeit bewirkt.

Dies kann dazu führen, dass zwischenzeitlich das FB-Signal dem CLK-Signal so weit vorauseilt (insbesondere z.B. die positive Flanke des FB-Signals die negative Flanke des CLK-Signals "überholt" hat), dass von der Phasenvergleichseinrichtung erneut ein INC-Signal ausgegeben wird, etc., etc., sodaß das CLK- und das FB-Signal nicht synchronisiert, d.h. die Taktsignal-Synchronisationseinrichtung nicht "eingerastet" werden kann.

In der Druckschrift US 2002/027430 A1 ist eine Vorrichtung zur Verwendung bei der Synchronisation von Taktsignalen gezeigt, mit einer Verzögerungseinrichtung mit variabel steuerbarer Verzögerungszeit, in die ein Taktsignal eingegeben, mit der variabel steuerbaren Verzögerungszeit beaufschlagt, und als verzögertes Taktsignal ausgegeben wird. Des weiteren ist eine Einrichtung vorgesehen zum Ermitteln, ob eine Taktflanke des von der Verzögerungseinrichtung ausgegebenen verzögerten Taktsignals, oder eines hieraus gewonnenen Signals innerhalb eines vorbestimmten Zeitfensters vor einer entsprechenden Taktflanke des Taktsignals oder des hieraus gewonnenen Signals liegt. In den Druckschriften US-B1-6 388 482, US 2002/180501 A1 und Tae-Sung Kim et. al: "A low jitter, fast locking delay locked loop using measure and control scheme", Mixed-Signal Design, 2001, Southwest Symposium on Feb. 25-27, Seiten 45-50 sind Taktsignal-Synchronisationsvorrichtungen bzw. -verfahren offenbart, bei denen zunächst eine Grob- und dann eine Feineinstellung erfolgt. In der Druckschrift US-A-5790612 ist eine Vorrichtung zur Verwendung bei der Synchronisation von Taktsignalen gezeigt, bei welcher ermittelt wird, ob eine Flanke eines Taktsignals innerhalb eines vorbestimmten Zeitfensters liegt. Hierbei wird ein zusätzlich vorgesehenes Verzögerungselement verwendet, welches eine fest vorgegebene Verzögerung verursacht.

Die Aufgabe der Erfindung besteht darin, eine neuartige Vorrichtung zur Verwendung bei der Synchronisation von Taktsignalen, sowie ein neuartiges Taktsignal-Synchronisationsverfahren zur Verfügung zu stellen, insbesondere eine Vorrichtung und ein Verfahren, mit denen die beschriebenen Nachteile bisheriger entsprechender Vorrichtungen bzw. Verfahren zumindest teilweise beseitigt werden können. Die Erfindung erreicht dieses und andere Ziele durch den Gegenstand der Ansprüche 1 und 4. Vorteilhafte weiterbildungen der Erfindung sind in den Unteransprüchen angegeben.

Im folgenden wird die Erfindung anhand von Ausführungsbeispielen und der beigefügten Zeichnung näher erläutert. In der Zeichnung zeigen:
Fig. 1 eine schematische Darstellung einer Taktsignal-Synchronisationseinrichtung gemäß einem Ausführungsbeispiel der Erfindung;
Fig. 2 eine schematische Detaildarstellung einer bei der Taktsignal-Synchronisationseinrichtung gemäß Figur 1 zur Steuerung des Taktsignal-Synchronisations-Prozesses verwendeten Steuer-Vorrichtung;
Fig. 3 Zeitablaufdiagramme der in die in Figur 2 gezeigte Steuer-Vorrichtung eingegebenen FB- und CLK-Signale, und des von der Steuer-Vorrichtung ausgegebenen, zur Steuerung des Taktsignal-Synchronisations-Prozesses verwendeten Steuersignals (SLOW-Signals); und
Fig. 4 eine schematische Detaildarstellung der in der Steuer-Vorrichtung gemäß Figur 2 verwendeten Verzögerungseinrichtung.

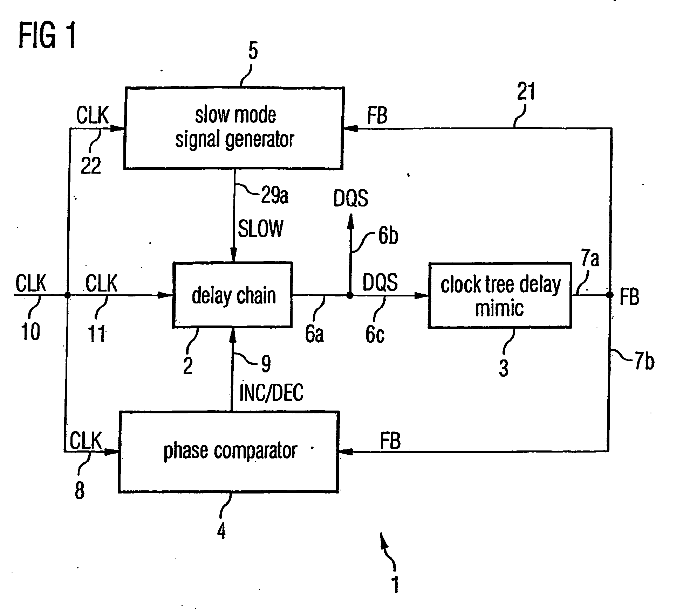

In Figur 1 ist eine schematische Darstellung einer Taktsignal-Synchronisationseinrichtung 1 gemäß einem Ausführungsbeispiel der Erfindung gezeigt.

Diese weist - entsprechend ähnlich wie herkömmliche Taktsignal-Synchronisationseinrichtungen - eine erste Verzögerungseinrichtung 2, eine zweite Verzögerungseinrichtung 3, und eine Phasenvergleichseinrichtung 4 auf, sowie - anders als herkömmliche Taktsignal-Synchronisationseinrichtungen, und wie im folgenden noch genauer erläutert wird - eine speziell ausgestaltete, zur Steuerung des Taktsignal-Synchronisations-Prozesses verwendete Steuer-Vorrichtung 5.

Die Taktsignal-Synchronisationseinrichtung 1 kann z.B. auf einem Halbleiter-Bauelement vorgesehen sein, insbesondere einem Speicherbauelementen wie einem - z.B. auf CMOS-Technologie beruhenden - DRAM (DRAM = Dynamic Random Access Memory bzw. dynamischer Schreib-Lese-Speicher), z.B. einem DDR-DRAM (DDR-DRAM = Double Data Rate - DRAM bzw. DRAM mit doppelter Datenrate).

Das entsprechende Halbleiter-Bauelement weist einen - externen - Anschluß auf (z.B. ein entsprechendes Pad bzw. einen entsprechenden Pin), an dem - zur zeitlichen Koordination der Verarbeitung bzw. Weiterschaltung der Daten im Halbleiter-Bauelement - von einem externen Taktsignal-Geber ein externes Taktsignal CLK angelegt wird.

Alternativ kann das Bauelement einen entsprechenden - weiteren - externen Anschluß (z.B. ein entsprechendes weiteres Pad bzw. einen entsprechenden weiteren Pin) aufweisen, an dem ein zum o.g. Taktsignal CLK inverses Taktsignal BCLK angelegt wird (d.h. es können sog. "differentielle" Taktsignale CLK, BCLK verwendet werden).

Intern im Bauelement können die Daten z.B. jeweils bei der ansteigenden (oder alternativ z.B. jeweils bei der abfallenden) Taktflanke des o.g. Taktsignals CLK (bzw. - genauer - eines hieraus gewonnenen, internen DQS-Taktsignals) weitergeschaltet werden, bzw. - bei der Verwendung differentieller Taktsignale CLK und BCLK (bzw. - genauer - der hieraus gewonnenen, differentiellen, internen Taktsignale DQS und BDQS) - i.A. sowohl bei der ansteigenden Flanke des CLK- als auch der ansteigenden Flanke des BCLK-Taktsignals (bzw. sowohl der ansteigenden Flanke des DQS- als auch der ansteigenden Flanke des BDQS-Signals (bzw. bei jeweils den abfallenden Taktflanken der entsprechenden Signale)).

Wie in Figur 1 gezeigt ist, wird das - am entsprechenden Anschluß des Halbleiter-Bauelements anliegende - CLK-Signal über eine Leitung 10, und eine mit dieser verbundenen Leitung 11 der in der Taktsignal-Synchronisationseinrichtung 1 vorgesehenen ersten Verzögerungseinrichtung 2 zugeführt.

In der ersten Verzögerungseinrichtung 2 ("delay chain" bzw. "delay line") wird das CLK-Signal - abhängig von einem von der Phasenvergleichseinrichtung 4 ausgegebenen Steuersignal INC bzw. DEC - mit einer - durch das Steuersignal einstellbaren, variablen - Verzögerungszeit tᵥₐᵣ beaufschlagt.

Das von der ersten Verzögerungseinrichtung 2 an einer Leitung 6a, und einer mit dieser verbundenen Leitung 6b ausgegebene - gegenüber dem CLK-Signal um die o.g. variable Verzögerungszeit tᵥₐᵣ verzögerte - Signal DQS (bzw. zusätzlich ein - hierzu inverses - Signal BDQS) kann (bzw. können) - intern - im Bauelement zur zeitlichen Koordination der Verarbeitung bzw. Weiterschaltung der Daten verwendet werden (d.h. als - interne(s) - Taktsignal(e) DQS bzw. BDQS).

Das BDQS-Signal kann z.B. - durch invertieren - aus dem DQS-Signal erzeugt werden, oder kann z.B. separat erzeugt werden (z.B. aus dem BCLK-Signal, unter Verwendung einer der in Figur 1 gezeigten Taktsignal-Synchronisationseinrichtung 1 entsprechenden Taktsignal-Synchronisationseinrichtung).

Wie aus Figur 1 weiter hervorgeht, wird das von der ersten Verzögerungseinrichtung 2 ausgegebene Signal DQS - über die o.g. Leitung 6a, und eine mit dieser verbundene Leitung 6c - (zusätzlich auch) der o.g. zweiten Verzögerungseinrichtung 3 ("clock tree delay mimic") zugeführt, die das eingegebene Signal DQS mit einer - festen - Verzögerung t_{const} beauschlagt, die z.B. in etwa der Summe der durch den bzw. die Receiver ("Receiver-Delay"), den jeweiligen Datenpfad ("data path delay"), und den bzw. die Off-Chip-Driver ("OCD-Delay") verursachten Signal-Verzögerungen entspricht.

Das von der zweiten Verzögerungseinrichtung 3 an einer Leitung 7a ausgegebene - und gegenüber dem DQS-Signal um die o.g. feste Verzögerungszeit t_{const} verzögerte - Signal (FB-Signal bzw. "Feedback-Signal") wird über eine - mit der Leitung 7a verbundene - Leitung 7b einem ersten Eingang der Phasenvergleichseinrichtung 4 zugeführt, sowie über eine - ebenfalls mit der Leitung 7a verbundene - Leitung 21 (und wie im folgenden noch genauer erläutert wird) der Steuer-Vorrichtung 5 ("Slow Mode Signal Generator").

Wie aus Figur 1 weiter hervorgeht, wird das an der Leitung 10 anliegende CLK-Signal - über eine mit der Leitung 10 verbundene Leitung 8 - einem (weiteren) Eingang der Phasenvergleichseinrichtung 4 zugeführt, sowie über eine - ebenfalls mit der Leitung 10 verbundene - Leitung 22 (und wie im folgenden noch genauer erläutert wird) der Steuer-Vorrichtung 5 ("Slow Mode Signal Generator").

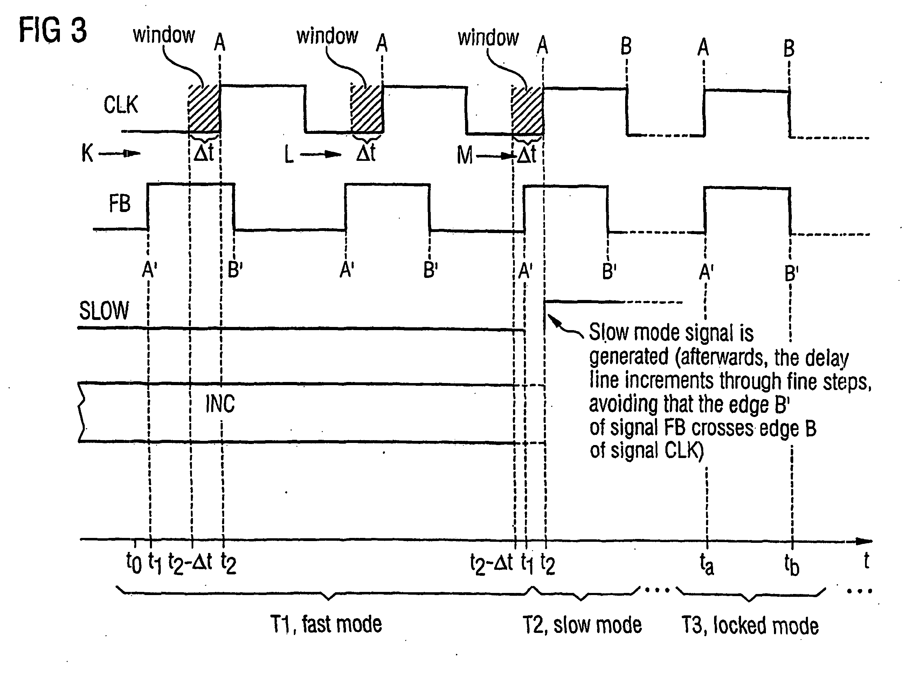

In der Phasenvergleichseinrichtung 4 wird - entsprechend ähnlich wie bei herkömmlichen Phasenvergleichseinrichtungen - die Phasenlage des - an der Leitung 7b anliegenden, dem ersten Eingang der Phasenvergleichseinrichtung 4 zugeführten - FB-Signals mit derjenigen des - an der Leitung 8 anliegenden, dem weiteren Eingang der Phasenvergleichseinrichtung 4 zugeführten - CLK-Signals verglichen. Abhängig davon, ob die Phase des FB-Signal derjenigen des CLK-Signals vorauseilt, oder hinterherläuft, wird von der Phasenvergleichseinrichtung 4 - als Steuersignal für die o.g. erste Verzögerungseinrichtung 2 - an einer mit der ersten Verzögerungseinrichtung 2 verbundenen Steuerleitung 9 ein Inkrement-Signal (INC-Signal), oder ein Dekrement-Signal (DEC-Signal) ausgegeben (z.B. - als INC-Signal - ein "logisch hohes", und - als DEC-Signal - ein "logisch niedriges' Signal (oder umgekehrt)), die dazu führen, dass die durch die erste Signalverzögerungseinrichtung 2 bewirkte Verzögerung tᵥₐᵣ des CLK-Signals - bei einem INC-Signal - erhöht wird (vgl. z.B. das in Figur 3 gezeigte INC-Signal, und das in den Zeiträumen T1 bzw. T2 ("fast mode" bzw. "slow mode") jeweils geringer werdende Vorauseilen des FB-Signals gegenüber dem CLK-Signal (Pfeile K, L, M)), bzw. - bei einem DEC-Signal - verringert wird, sodaß schließlich das CLK- und das FB-Signal synchronisiert, d.h. die Taktsignal-Synchronisationseinrichtung 1 "eingerastet" ("locked") ist (d.h. - wie z.B. in Figur 3, ganz rechts dargestellt - das CLK-Signal jeweils zur gleichen Zeit tₐ eine positive Flanke A hat, wie das FB-Signal (Flanke A') (bzw. das CLK-Signal jeweils zur gleichen Zeit t_{b} eine negative Flanke B hat, wie das FB-Signal (Flanke B')) (Zeitraum T3, "locked mode")).

Solange die positive Flanke A' des FB-Signals der positiven Flanke A des CLK-Signals vorauseilt (wie z.B. in Figur 3, links dargestellt), wird von der Phasenvergleichseinrichtung 4 - als Steuersignal für die o.g. erste Verzögerungseinrichtung 2 - an der Leitung 9 ein INC-Signal ausgegeben. Demgegenüber würde in dem Fall, dass die positive Flanke A' des FB-Signals die positive Flanke A des CLK-Signals "überholt", von der Phasenvergleichseinrichtung 4 - als Steuersignal für die o.g. erste Verzögerungseinrichtung 2 - an der Leitung 9 ein DEC-Signal ausgegeben.

Wird - in einer ersten Phase (Zeitraum T1, "fast mode") - von der Phasenvergleichseinrichtung 4 ein INC-Signal (oder alternativ: ein DEC-Signal) ausgegeben, und liegt (wie z.B. in Figur 3, links dargestellt) die positive Flanke A' des FB-Signals außerhalb eines vorbestimmten, direkt vor der positiven Flanke A des CLK-Signals liegenden, eine vorbestimmte, konstante Zeitdauer Δt lang andauernden Zeitfensters (in Figur 3 schraffiert dargestellt) - d.h. tritt die positive Flanke A' des FB-Signals z.B. zu einem Zeitpunkt t1 auf, der länger als die o.g. Zeitdauer Δt vor dem Zeitpunkt t2 liegt, zu dem die positive Flanke A des CLK-Signals auftritt (d.h. gilt t2 - Δt > t1) -, wird die von der ersten Signalverzögerungseinrichtung 2 bewirkte Verzögerung tᵥₐᵣ in relativ großen Zeitschritten, d.h. relativ stark (d.h. jeweils in Grobschritten, z.B. um jeweils eine "coarse unit delay" t_{c} bzw. Grob-Einheit-Verzögerung) erhöht (bzw. verringert), bzw. die Phasengeschwindigkeit des FB-Signals gegenüber der Phasengeschwindigkeit des CLK-Signals - relativ stark - vergrößert (bzw. verkleinert) ("Grobeinstellung").

Wird - in einer zweiten Phase (Zeitraum T2, "slow mode") - von der Phasenvergleichseinrichtung 4 ein INC-Signal (oder ein DEC-Signal) ausgegeben, und liegt (wie z.B. in Figur 3 weiter rechts dargestellt) die positive Flanke A' des FB-Signals innerhalb des o.g. vorbestimmten, direkt vor der positiven Flanke A des CLK-Signals liegenden, die o.g. vorbestimmte, konstante Zeitdauer Δt lang andauernden Zeitfensters (in Figur 3 schraffiert dargestellt) - d.h. tritt die positive Flanke A' des FB-Signals zu einem Zeitpunkt t1 auf, der kürzer als die o.g. Zeitdauer Δt vor dem Zeitpunkt t2 liegt, zu dem die positive Flanke A des CLK-Signals auftritt (d.h. gilt t2 - Δt ≤ t1) -, wird die von der ersten Signalverzögerungseinrichtung 2 bewirkte Verzögerung tᵥₐᵣ in relativ kleinen Zeitschritten, d.h. relativ schwach (d.h. jeweils in Feinschritten, z.B. um jeweils eine "fine unit delay" t_{f} bzw. Fein-Einheit-Verzögerung) erhöht (bzw. verringert), bzw. die Phasengeschwindigkeit des FB-Signals gegenüber der Phasengeschwindigkeit des CLK-Signals - relativ schwach - vergrößert (bzw. verkleinert) ("Feineinstellung").

Eine "coarse unit delay" t_{c} bzw. Grob-Einheit-Verzögerung kann um einen bestimmten Faktor (z.B. zwischen drei und zwanzig Mal, beispielsweise vier, acht oder sechzehn Mal) größer sein, als eine "fine unit delay" t_{f} bzw. Fein-Einheit-Verzögerung (d.h. es kann z.B. gelten: t_{c} = 4 t_{f}, oder z.B. t_{c} = 8 t_{f}, oder z.B. t_{c} = 16 t_{f}, etc.).

Ob die von der ersten Signalverzögerungseinrichtung 2 bewirkte Verzögerung tᵥₐᵣ in relativ kleinen Zeitschritten, d.h. relativ schwach (d.h. jeweils in Feinschritten, z.B. um jeweils die o.g. "fine unit delay" t_{f}) erhöht (bzw. verringert) wird - d.h. das System sich im o.g. "slow mode" befindet -, oder ob die von der ersten Signalverzögerungseinrichtung 2 bewirkte Verzögerung tᵥₐᵣ in relativ großen Zeitschritten, d.h. relativ stark (d.h. jeweils in Grobschritten, z.B. um jeweils die o.g. "coarse unit delay" t_{c}) erhöht (bzw. verringert) wird - d.h. das System sich im o.g. "fast mode" befindet -, wird - wie im folgenden noch genauer erläutert wird - von der o.g. Steuer-Vorrichtung 5 ermittelt.

Wird von der o.g. Steuer-Vorrichtung 5 ermittelt, dass sich das System im "fast mode" befindet (d.h. wird von der Steuer-Vorrichtung 5 ermittelt, dass die positive Flanke A' des FB-Signals außerhalb des vorbestimmten, direkt vor der positiven Flanke A des CLK-Signals liegenden Zeitfensters liegt), wird von der Steuer-Vorrichtung 5 ein "logisch niedriges" Steuersignal ausgegeben, und - über eine Leitung_29a - der ersten Signalverzögerungseinrichtung 2 zugeführt (die dann - wie oben erläutert - die von ihr bewirkte Verzögerungszeit tᵥₐᵣ in relativ großen Zeitschritten, d.h. relativ stark erhöht (bzw. verringert)).

Wird demgegenüber von der o.g. Steuer-Vorrichtung 5 ermittelt, dass sich das System im "slow mode" befindet (d.h. wird von der Steuer-Vorrichtung 5 ermittelt, dass die positive Flanke A' des FB-Signals innerhalb des vorbestimmten, direkt vor der positiven Flanke A des CLK-Signals liegenden Zeitfensters liegt), wird von der Steuer-Vorrichtung 5 ein "logisch hohes" Steuersignal (SLOW-Signal) ausgegeben, und - über die o.g. Leitung 29a - der ersten Signalverzögerungseinrichtung 2 zugeführt (die dann - wie oben erläutert - die von ihr bewirkte Verzögerungszeit tᵥₐᵣ nur noch in relativ kleinen Zeitschritten, d.h. relativ schwach erhöht (bzw. verringert)).

Die Zeitdauer At des Zeitfensters kann z.B. ein Vielfaches der o.g. "coarse unit delay" t_{c} bzw. Grob-Einheit-Verzögerung betragen, z.B. zwischen dem zwei- und sechzehnfachen der o.g. "coarse unit delay" t_{c} (beim vorliegenden Ausführungsbeispiel insbesondere - und wie im folgenden noch genauer erläutert wird abhängig von der Frequenz des CLK-Signals - entweder dem zweifachen, oder dem vierfachen der o.g. "coarse unit delay" t_{c} bzw. Grob-Einheit-Verzögerung).

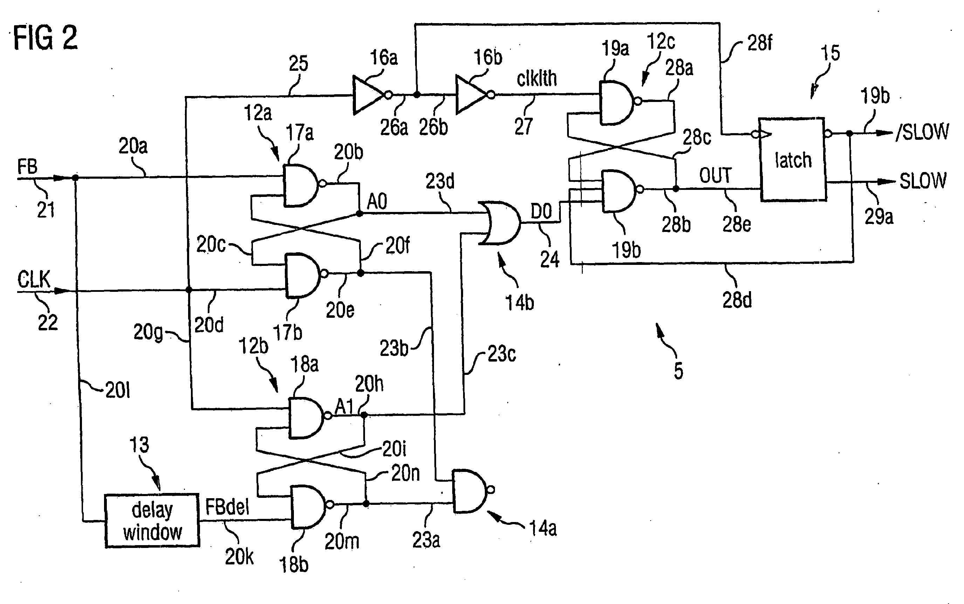

In Figur 2 ist eine schematische Detaildarstellung der in der Taktsignal-Synchronisationseinrichtung 1 gemäß Figur 1 zur Steuerung des Taktsignal-Synchronisations-Prozesses verwendeten Steuer-Vorrichtung 5 gezeigt:

Wie aus Figur 2 hervorgeht, weist die Steuer-Vorrichtung 5 ein erstes und ein zweites - entsprechend verschaltetes - RS-Flip-Flop 12a, 12b auf, einen - weiteren - Flip-Flop 12c, eine Verzögerungseinrichtung 13, ein NAND-Gatter 14a, ein OR-Gatter 14b, ein Latch 15, sowie zwei Inverter-16a, 16b.

Das erste RS-Flip-Flop 12a weist zwei NAND-Gatter 17a, 17b auf (hier: zwei 2-NAND-Gatter 17a, 17b), und das zweite RS-Flip-Flop 12b zwei NAND-Gatter 18a, 18b (hier: zwei 2-NAND-Gatter 18a, 18b).

Ein erster Eingang des ersten NAND-Gatters 17a des ersten RS-Flip-Flops 12a ist - über eine Leitung 20a - mit der o.g. Leitung 21 verbunden, über die das o.g. FB-Signal in die Steuer-Vorrichtung 5 eingegeben wird.

Der Ausgang des ersten NAND-Gatters 17a des ersten RS-Flip-Flops 12a ist - über eine Leitung 20b, und eine mit dieser verbundenen Leitung 20c - an einen ersten Eingang des zweiten NAND-Gatters 17b des ersten RS-Flip-Flops 12a rückgekoppelt (so dass ein am Ausgang des ersten NAND-Gatters 17a des ersten RS-Flip-Flops 12a ausgegebenes Signal (A0-Signal) dem ersten Eingang des zweiten NAND-Gatters 17b des ersten RS-Flip-Flops 12a zugeführt wird).

Des weiteren ist ein zweiter Eingang des zweiten NAND-Gatters 17b des ersten RS-Flip-Flops 12a - über eine Leitung 20d - mit der o.g. Leitung 22 verbunden, über die das o.g. CLK-Signal in die Steuer-Vorrichtung 5 eingegeben wird.

Der Ausgang des zweiten NAND-Gatters 17b des ersten RS-Flip-Flops 12a ist - über eine Leitung 20e, und eine mit dieser verbundenen Leitung 20f - an einen zweiten Eingang des ersten NAND-Gatters 17a des ersten RS-Flip-Flops 12a rückgekoppelt (so dass ein am Ausgang des zweiten NAND-Gatters 17b des ersten RS-Flip-Flops 12a ausgegebenes Signal dem zweiten Eingang des ersten NAND-Gatters 17a des ersten RS-Flip-Flops 12a zugeführt wird).

Wie aus Figur 2 weiter hervorgeht, ist ein erster Eingang des ersten NAND-Gatters 18a des zweiten RS-Flip-Flops 12b - über eine Leitung 20g - mit der o.g. Leitung 22 verbunden, über die das o.g. CLK-Signal in die Steuer-Vorrichtung 5 eingegeben wird.

Der Ausgang des ersten NAND-Gatters 18a des zweiten RS-Flip-Flops 12b ist - über eine Leitung 20h, und eine mit dieser verbundenen Leitung 20i - an einen ersten Eingang des zweiten NAND-Gatters 18b des zweiten RS-Flip-Flops 12b rückgekoppelt (so dass ein am Ausgang des ersten NAND-Gatters 18a des zweiten RS-Flip-Flops 12b ausgegebenes Signal (A1-Signal) dem ersten Eingang des zweiten NAND-Gatters 18b des zweiten RS-Flip-Flops 12b zugeführt wird).

Des weiteren ist ein zweiter Eingang des zweiten NAND-Gatters 18b des zweiten RS-Flip-Flops 12b - über eine Leitung 20k - mit einem Ausgang der o.g. Verzögerungseinrichtung 13 verbunden, deren Eingang - über eine Leitung 201 - mit der o.g. Leitung 21 verbunden ist (sodaß ein - gegenüber dem an der Leitung 21 anliegenden FB-Signal - durch die Verzögerungseinrichtung 13 entsprechend verzögertes Signal FBdel an den zweiten Eingang des zweiten NAND-Gatters 18b des zweiten RS-Flip-Flops 12b angelegt wird).

Der Ausgang des zweiten NAND-Gatters 18b des zweiten RS-Flip-Flops 12b ist - über eine Leitung 20m, und eine mit dieser verbundenen Leitung 20n - an einen zweiten Eingang des ersten NAND-Gatters 18a des zweiten RS-Flip-Flops 12b rückgekoppelt (so dass ein am Ausgang des zweiten NAND-Gatters 18b des zweiten RS-Flip-Flops 12b ausgegebenes Signal dem zweiten Eingang des ersten NAND-Gatters 18a des zweiten RS-Flip-Flops 12b zugeführt wird).

Wie aus Figur 2 weiter hervorgeht, wird das am Ausgang des zweiten NAND-Gatters 18b des zweiten RS-Flip-Flops 12b ausgegebene Signal zusätzlich auch - über die o.g. Leitung 20m, und eine mit dieser verbundenen Leitung 23a - einem zweiten Eingang des NAND-Gatters 14a zugeführt.

Auf entsprechend ähnliche Weise wird auch das am Ausgang des zweiten NAND-Gatters 17b des ersten RS-Flip-Flops 12a ausgegebene Signal (außer - über die o.g. Leitungen 20e, 20f - dem zweiten Eingang des ersten NAND-Gatters 17a des ersten RS-Flip-Flops 12a) zusätzlich auch - über die o.g. Leitung 20e, und eine mit dieser verbundenen Leitung 23b - einem ersten Eingang des NAND-Gatters 14a zugeführt.

Hierdurch wird erreicht, dass die am Ausgang des zweiten NAND-Gatters 17b des ersten RS-Flip-Flops 12a, und die am Ausgang des zweiten NAND-Gatters 18b des zweiten RS-Flip-Flops 12b anliegende (u.a. durch das NAND-Gatter 14a gebildete) Last im wesentlichen gleich groß ist, wie die am Ausgang des ersten NAND-Gatters 17a des ersten RS-Flip-Flops 12a, und die am Ausgang des ersten NAND-Gatters 18a des zweiten RS-Flip-Flops 12b anliegende (u.a. durch das OR-Gatter 14b gebildete) Last.

Wie aus Figur 2 weiter hervorgeht, wird das am Ausgang des ersten NAND-Gatters 17a des ersten RS-Flip-Flops 12a ausgegebene Signal (A0-Signal) (außer - über die o.g. Leitungen 20b, 20c - dem ersten Eingang des zweiten NAND-Gatters 17b des ersten RS-Flip-Flops 12a) zusätzlich auch - über die o.g. Leitung 20b, und eine mit dieser verbundenen Leitung 23d - einem ersten Eingang des OR-Gatters 14b zugeführt.

Auf entsprechend ähnliche Weise wird auch das am Ausgang des ersten NAND-Gatters 18a des zweiten RS-Flip-Flops 12b ausgegebene Signal (A1-Signal) (außer - über die o.g. Leitungen 20h, 20i - dem ersten Eingang des zweiten NAND-Gatters 18b des zweiten RS-Flip-Flops 12b) zusätzlich auch - über die o.g. Leitung 20h, und eine mit dieser verbundenen Leitung 23c - einem zweiten Eingang des OR-Gatters 14b zugeführt.

Der Ausgang des OR-Gatters 14b ist über eine Leitung 24 mit dem o.g. (dritten) Flip-Flop 12c der Steuer-Vorrichtung 5 verbunden (und zwar mit einem dritten Eingang eines NAND-Gatters 19b (hier: eines 3-NAND-Gatters 19b) des Flip-Flops 12c).

Wie aus Figur 2 weiter hervorgeht, weist das Flip-Flop 12c - zusätzlich zum NAND-Gatter 19b - ein weiteres NAND-Gatter 19a auf (hier: ein 2-NAND-Gatter 19a).

Gemäß Figur 2 ist ein Eingang des o.g. (ersten) Inverters 16a - über eine Leitung 25 - mit der o.g. Leitung 22 verbunden, über die - wie bereits oben erwähnt - das CLK-Signal in die Steuer-Vorrichtung 5 eingegeben wird.

Ein Ausgang des (ersten) Inverters 16a ist - über eine Leitung 26a, und eine mit dieser verbundenen Leitung 26b - an einen Eingang des (zweiten) Inverters 16b angeschlossen.

Des weiteren ist ein Ausgang des (zweiten) Inverters 16b - über eine Leitung 27 - mit einem ersten Eingang des ersten NAND-Gatters 19a des dritten Flip-Flops 12c der Steuer-Vorrichtung 5 verbunden (sodaß ein am Ausgang des zweiten Inverters 16b ausgegebenes Signal (clklth-Signal) dem ersten Eingang des ersten NAND-Gatters 19a des dritten Flip-Flops 12c zugeführt wird).

Der Ausgang des ersten NAND-Gatters 19a des dritten Flip-Flops 12c ist - über eine Leitung 28a - an einen.ersten Eingang des zweiten NAND-Gatters 19b des dritten Flip-Flops 12c rückgekoppelt (so dass ein am Ausgang des ersten NAND-Gatters 19a des Flip-Flops 12c ausgegebenes Signal dem ersten Eingang des zweiten NAND-Gatters 19b des Flip-Flops 12c zugeführt wird).

Auf entsprechend umgekehrte Weise ist der Ausgang des zweiten NAND-Gatters 19b des Flip-Flops 12c - über eine Leitung 28b, und eine mit dieser verbundenen Leitung 28c - an einen zweiten Eingang des ersten NAND-Gatters 19a des Flip-Flops 12c rückgekoppelt (so dass ein am Ausgang des zweiten NAND-Gatters 19b des Flip-Flops 12c ausgegebenes Signal (OUT-Signal) dem zweiten Eingang des ersten NAND-Gatters 19b des Flip-Flops 12c zugeführt wird).

Ein zweiter Eingang des zweiten NAND-Gatters 19b des Flip-Flops 12c ist - über eine Leitung 28d - an eine - mit einem ersten (inversen) Ausgang des Latches 15 verbundene - Leitung 29b angeschlossen.

Ein (Däten-)Eingang des Latches 15 ist über eine Leitung 28e, und die mit dieser verbundene Leitung 28b an den Ausgang des zweiten NAND-Gatters 19b des Flip-Flops 12c angeschlossen (sodaß das am Ausgang des zweiten NAND-Gatters 19b des Flip-Flops 12c ausgegebene OUT-Signal dem o.g. (Daten-)Eingang des Latches 15 zugeführt wird).

Wie aus Figur 2 weiter hervorgeht, ist der Ausgang des (ersten) Inverters 16a - über die o.g. Leitung 26a, und eine mit dieser verbundenen Leitung 28f - an den einen (inversen) (Takt-) Eingang des Latches 15 angeschlossen.

Der (zweite, nicht-inverse) Ausgang des Latches 15 ist an die - oben bereits erwähnte - Leitung 29a angeschlossen, und der (erste, inverse) Ausgang des Latches 15 an die o.g. Leitung 29b (so dass das am zweiten, nicht-inversen Ausgang des Latches 15 ausgegebene (Steuer-)Signal (SLOW-Signal) - wie aus Figur 1 hervorgeht - über die o.g. Leitung 29a der ersten Verzögerungseinrichtung 2 der Taktsignal-Synchronisationseinrichtung 1 zugeführt wird, und - wie aus Figur 2 hervorgeht, und wie bereits oben erläutert wurde - das zum SLOW-Signal inverse Signal /SLOW - über die Leitung 28d - dem zweiten Eingang des zweiten NAND-Gatters 19b des dritten Flip-Flops 12c).

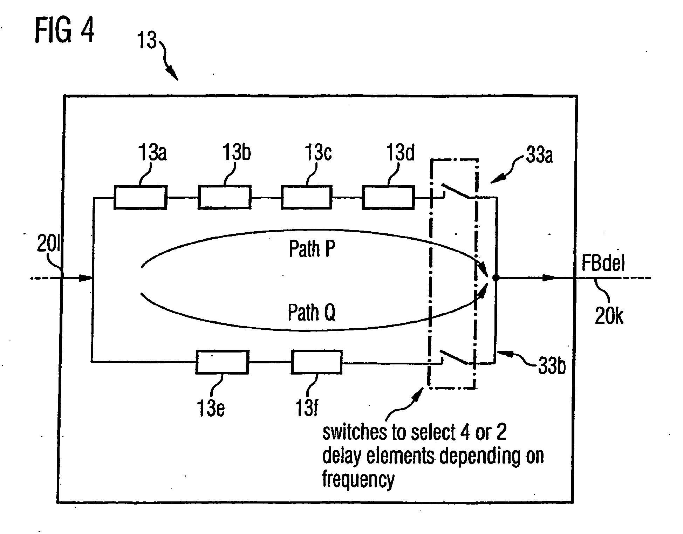

In Fig. 4 ist eine schematische Detaildarstellung der in der Steuer-Vorrichtung 5 gemäß Figur 2 verwendeten Verzögerungseinrichtung 13 gezeigt. Diese weist z.B. - in einem ersten Signalpfad P liegend - vier Verzögerungs-Elemente 13a, 13b, 13c, 13d auf, und - in einem zweiten Signalpfad Q liegend - zwei Verzögerungs-Elemente 13e, 13f.

Jedes der Verzögerungs-Elemente 13a, 13b, 13c, 13d, 13e, 13f bewirkt eine Verzögerung des jeweils eingegebenen Signals um die o.g. - in Bezug auf die o.g. erste Verzögerungseinrichtung 2 bereits erläuterte - "coarse unit delay" t_{c} bzw. Grob-Einheit-Verzögerung (wobei in der in Figur 1 gezeigten ersten Verzögerungseinrichtung 2 der Taktsignal-Synchronisationseinrichtung 1 entsprechend identische Verzögerungs-Elemente verwendet werden, wie in der in Figur 2 und 4 gezeigten Verzögerungseinrichtung 13 der Steuer-Vorrichtung 5).

Je nachdem, ob die (z.B. von einer entsprechenden Frequenz-Ermittlungs-Einrichtung ermittelte) Frequenz des CLK-Signals über oder unter einem vorbestimmten Schwellwert S liegt, werden entsprechende in der Verzögerungseinrichtung 13 vorgesehene Schalter 33a, 33b entsprechend - automatisch (und z.B. unter Steuerung durch die o.g. Frequenz-Ermittlungs-Einrichtung) - geöffnet, oder geschlossen (sodaß - bei einer relativ niedrigen Frequenz des CLK-Signals - das in die Verzögerungseinrichtung 13 eingegebene Signal z.B. durch die vier Verzögerungs-Elemente 13a, 13b, 13c, 13d (d.h. relativ stark) verzögert wird (Signalpfad P (bzw. Schalter 33a) geschlossen, und Signalpfad Q (bzw. Schalter 33b) geöffnet)), und - bei einer relativ hohen Frequenz des CLK-Signals - das in die Verzögerungseinrichtung 13 eingegebene Signal lediglich durch die zwei Verzögerungs-Elemente 13e, 13f (d.h. relativ schwach) verzögert wird (Signalpfad P (bzw. Schalter 33a) geöffnet, und Signalpfad Q (bzw. Schalter 33b) geschlossen)).

Der o.g. Schwellwert S für die Frequenz kann z.B. zwischen 100 MHz und 1000 MHz liegen, z.B. bei 250 MHz.

Mit anderen Worten kann also durch die Schalter 33a, 33b die "Weite" bzw. die o.g. Zeitdauer Δt des in Figur 3 gezeigten, jeweils unmittelbar vor der positiven Flanke A des CLK-Signals liegenden Zeitfensters (in Figur 3 schraffiert dargestellt) - frequenzabhängig - geändert werden.

Sind - wie in Figur 3 gezeigt z.B. zu einem Anfangszeitpunkt t₀ - sowohl das CLK- als auch das FB-Signal in einem "logisch niedrigen" Zustand, wird - wie sich aus Figur 2 ergibt - vom ersten RS-Flip-Flop 12a (bzw. von dessen erstem NAND-Gatter 17a) an der o.g. Leitung 23d ein "logisch hohes" Signal ("A0-Signal") ausgegeben.

Auf entsprechend ähnliche Weise wird dann - wie sich ebenfalls aus Figur 2 ergibt - auch vom zweiten RS-Flip-Flop 12b (bzw. von dessen erstem NAND-Gatter 18a) an der entsprechenden Leitung 23c ein "logisch hohes" Signal ("A1-Signal") ausgegeben - das vom OR-Gatter 14b an der Leitung 24 ausgegebene Signal ("D0"-Signal) ist dann - ebenfalls - "logisch hoch".

Das vom OR-Gatter 14b an der Leitung 24 ausgegebene Signal ("D0"-Signal) wird nur dann "logisch niedrig", wenn sowohl das vom ersten RS-Flip-Flop 12a an der o.g. Leitung 23d ausgegebene A0-Signal, als auch das vom zweiten RS-Flip-Flop 12b an der entsprechenden Leitung 23c ausgegebene A1-Signal "logisch niedrig" ist. Mit einem "logisch niedrigen- D0-Signal.wird angezeigt, dass in den "slow mode" gewechselt werden soll.

Dies ist nur dann der Fall (d.h. das D0-signal wird nur dann "logisch niedrig"), wenn - wie im folgenden noch erläutert wird - die positive Flanke A' des FB-Signals - wie z.B. in Figur 3, rechts dargestellt - innerhalb des o.g., direkt vor der positiven Flanke A des CLK-Signals liegenden, die o.g. Zeitdauer Δt lang andauernden Zeitfensters liegt (in Figur 3 schraffiert dargestellt) - d.h. die positive Flanke A' des FB-Signals z.B. zu einem Zeitpunkt t1 auftritt, der kürzer als die o.g. Zeitdauer Δt vor dem Zeitpunkt t2 liegt, zu dem die positive Flanke A des CLK-Signals auftritt.

Ansonsten (d.h. wenn die positive Flanke A' des FB-Signals - wie z.B. in Figur 3, links dargestellt - außerhalb des o.g. Zeitfensters liegt) wechselt - nach einer positiven Flanke A' des FB-Signals, und einer darauffolgenden positiven Flanke A des CLK-Signals - zwar das vom ersten RS-Flip-Flop 12a an der o.g. Leitung 23d ausgegebene Signal (A0-Signal) seinen Zustand auf "logisch niedrig".

Allerdings bleibt - nach einer positiven Flanke A' des FB-Signals, und einer darauffolgenden positiven Flanke A des CLK-Signals - das vom zweiten RS-Flip-Flop 12b an der o.g. Leitung 23c ausgegebene Signal (A1-Signal) in einem Zustand "logisch hoch" (da - trotz der durch die Verzögerungseinrichtung 13 bewirkten Verzögerung des FB-Signals um die o.g. Zeitdauer Δt - beim zweiten RS-Flip-Flop 12b zunächst am zweiten Eingang des zweiten NAND-Gatters 18b, und dann erst am ersten Eingang des ersten NAND-Gatters 18a (und nicht etwa in umgekehrter Reihenfolge) ein "logisch hohes" Signal anliegt (so dass durch das - zunächst am Ausgang des zweiten NAND-Gatters 18b ausgegebene, und dem zweiten Eingang des ersten NAND-Gatters 18a zugeführte - "logisch niedrige" Signal das erste NAND-Gatter 18a "blockiert" wird (d.h. selbst dann noch an der Leitung 23c ein "logisch hohes" Signal ausgibt, wenn das CLK-Signal seinen Zustand dann auf "logisch hoch" wechselt))).

Liegt demgegenüber die positive Flanke A' des FB-Signals - wie z.B. in Figur 3, rechts dargestellt - innerhalb des o.g., direkt vor der positiven Flanke A des CLK-Signals liegenden, die o.g. Zeitdauer Δt lang andauernden Zeitfensters, wechselt - nach einer positiven Flanke A' des FB-Signals, und einer darauffolgenden positiven Flanke A des CLK-Signals - das vom zweiten RS-Flip-Flop 12b an der o.g. Leitung 23c ausgegebene Signal (A1-Signal) - entsprechend wie das vom ersten RS-Flip-Flop 12a an der Leitung 23d ausgegebene Signal A0 - seinen Zustand auf "logisch niedrig" (da - durch die durch die Verzögerungseinrichtung 13 bewirkte Verzögerung des FB-Signals um die o.g. Zeitdauer Δt (und den relativ kurzen zeitlichen Abstand zwischen den Flanken A' und A) - beim zweiten RS-Flip-Flop 12b dann zunächst am ersten Eingang des ersten NAND-Gatters 18a, und dann erst am zweiten Eingang des zweiten NAND-Gatters 18b ein "logisch hohes" Signal anliegt (so dass durch das am ersten Eingang des ersten NAND-Gatters 18a dann anliegende "logisch hohe Signal", und das am zweiten Eingang des ersten NAND-Gatters 18a anliegende - ebenfalls "logisch hohe" - Signal am Ausgang des ersten NAND-Gatters 18a (und somit an der o.g. Leitung 23c) dann ein "logisch niedriges" A1-Signal ausgegeben wird)).

Durch das o.g. - auf die RS-Flip-Flops 12a, 12b,folgende - (dritte) Flip-Flop 12c, bzw. das Latch 15 wird das von dem OR-Gatter 14b ausgegebene, dann "logisch niedrige" D0-Signal (Slow-Mode-Ermittlungssignal) mit dem System-Takt (CLK-Signal) synchronisiert.

Nur dann, wenn das von dem OR-Gatter 14b an der Leitung 24 ausgegebene, in das NAND-Gatter 19b des dritten Flip-Flops 12c eingegebene Signal ("D0"-Signal) "logisch niedrig" wird (d.h., wenn in den "slow mode" gewechselt werden soll), kann - bei entsprechenden Takt-Flanken des CLK- bzw. (genauer) des hieraus gewonnenen clklth-Signals - das vom NAND-Gatter 19b an den Leitungen 28b, 28e ausgegebene OUT-Signal "logisch hoch" werden, und vom Latch 15 als "logisch hohes" Steuersignal SLOW dann an die Leitung 29a weitergeleitet werden.

Wird das an der Leitung 29a anliegende SLOW-Signal "logisch hoch" - und demzufolge das an der Leitung 29b anliegende, zum SLOW-Signal inverse Signal /SLOW logisch niedrig -, wird - über die Leitung 28d - dieses "logisch niedrige" Signal dann dem (zweiten) Eingang des NAND-Gatters 19b des Flip-Flops 12c zugeführt, und dadurch sichergestellt, dass das NAND-Gatter 19b - unabhängig von einer ggf. später eintretenden Zustandsänderung des am dritten Eingang des NAND-Gatters 19b anliegenden D0-Signals - im vorliegenden Zustand festgehalten wird, so dass das System - sobald einmal detektiert wurde, dass die positive Flanke A' des FB-Signals innerhalb des o.g., direkt vor der positiven Flanke A, des CLK-Signals liegenden, die o.g. Zeitdauer Δt lang andauernden Zeitfensters liegt - (bis zu einem Reset) im "slow mode"-Zustand verbleibt.

Vorteilhaft sind die o.g. Verzögerungseinrichtungen 2, 3 der Taktsignal-Synchronisationseinrichtung 1 und/oder die Steuer-Vorrichtung 5 - z.B. durch entsprechende Wahl der o.g. durch die Einrichtungen 2, 3 bzw. die in der Vorrichtung 5 vorgesehene Einrichtung 13 bewirkten Verzögerungen - so eingerichtet und ausgestaltet, dass verhindert wird, dass die positive Flanke A' des FB-Signals - z.B. ausgehend von dem in Figur 3, links gezeigten Zustand - die positive Flanke A des CLK-Signals überholen, oder alternativ: zu weit überholen kann.

Dadurch wird sichergestellt, dass eine schnelle und sichere Synchronisation des CLK- und FB-Signals erreicht, d.h. die Taktsignal-Synchronisationseinrichtung 1 schnell und sicher "eingerastet" bzw. in den "locked mode" gebracht werden kann.

### Bezugszeichenliste

- 1: Taktsignal-Synchronisationseinrichtung
- 2: erste Verzögerungseinrichtung
- 3: zweite Verzögerungseinrichtung
- 4: Phasenvergleichseinrichtung
- 5: Steuer-Vorrichtung
- 6a: Leitung
- 6b: Leitung
- 6c: Leitung
- 7a: Leitung
- 7b: Leitung
- 8: Leitung
- 9: Leitung
- 10: Leitung
- 11: Leitung
- 12a: RS-Flip-Flop
- 12b: RS-Flip-Flop
- 12c: Flip-Flop
- 13: Verzögerungseinrichtung
- 13a: Verzögerungs-Element
- 13b: Verzögerungs-Element
- 13c: Verzögerungs-Element
- 13d: Verzögerungs-Element
- 13e: Verzögerungs-Element
- 13f: Verzögerungs-Element
- 14a: NAND-Gatter
- 14b: OR-Gatter
- 15: Latch
- 16a: Inverter
- 16a: Inverter
- 17a: NAND-Gatter
- 17b: NAND-Gatter
- 18a: NAND-Gatter
- 18b: NAND-Gatter
- 19a: NAND-Gatter
- 19b: NAND-Gatter
- 20a: Leitung
- 20b: Leitung
- 20c: Leitung
- 20d: Leitung
- 20e: Leitung
- 20f: Leitung
- 20g: Leitung
- 20h: Leitung
- 20i: Leitung
- 20k: Leitung
- 201: Leitung
- 20m: Leitung
- 20n: Leitung
- 21: Leitung
- 22: Leitung
- 23a: Leitung
- 23b: Leitung
- 23c: Leitung
- 23d: Leitung
- 24: Leitung
- 25: Leitung
- 26a: Leitung
- 26b: Leitung
- 27: Leitung
- 28a: Leitung
- 28b: Leitung
- 28c: Leitung
- 28d: Leitung
- 28e: Leitung
- 28f: Leitung
- 29a: Leitung
- 29b: Leitung
- 33a: Schalter
- 33b: Schalter

## Patentansprüche

1. Vorrichtung (1) zur Verwendung bei der Synchronisation von Taktsignalen (CLK), mit einer Verzögerungseinrichtung (2) mit variabel steuerbarer, in variabel steuerbaren Zeitschritten verringerbarer oder erhöhbarer Verzögerungszeit (tᵥₐᵣ), in die ein Taktsignal (CLK) oder ein hieraus gewonnenes Signal eingegeben, mit der variabel steuerbaren, in variabel steuerbaren Zeitschritten verringerbaren oder erhöhbaren Verzögerungszeit (tᵥₐᵣ) beaufschlagt, und als verzögertes Taktsignal (DQS) ausgegeben wird,
wobei zusätzlich eine Einrichtung (5) vorgesehen ist zum Ermitteln, ob eine Taktflanke (A') des von der Verzögerungseinrichtung (2) ausgegebenen verzögerten Taktsignals (DQS), oder eines hieraus gewonnenen Signals (FB) innerhalb eines vorbestimmten Zeitfensters vor einer entsprechenden Taktflanke (A) des Taktsignals (CLK) oder des hieraus gewonnenen Signals liegt,
und wobei die Vorrichtung (1) so ausgestaltet und eingerichtet ist, dass dann, wenn von der Einrichtung (5) ermittelt wird, dass die Taktflanke (A') des von der Verzögerungseinrichtung (2) ausgegebenen verzögerten Taktsignals (DQS) oder des hieraus gewonnenen Signals (FB) innerhalb des vorbestimmten Zeitfensters vor der entsprechenden Taktflanke (A) des Taktsignals (CLK) oder des hieraus gewonnenen Signals liegt, die von der Verzögerungseinrichtung (2) bewirkte Signal-Verzögerungszeit (tᵥₐᵣ) in kleineren Zeitschritten, und damit langsamer verringert oder erhöht wird, als vor der Ermittlung,
**dadurch gekennzeichnet, dass** die Zeitdauer (Δt) des Zeitfensters abhängig von der von einer Frequenz-Ermittlungs-Einrichtung ermittelten Frequenz des Taktsignals (CLK) durch automatisches Umschalten einer Verzögerungs-Einrichtung (13) durch die Frequenz-Ermittlungs-Einrichtung gewählt ist.

2. Vorrichtung (1) nach Anspruch 1, welche so ausgestaltet und eingerichtet ist, dass dann, wenn ermittelt wird, dass die Taktflanke (A') des von der Verzögerungseinrichtung (2) ausgegebenen verzögerten Taktsignals (DQS), oder des hieraus gewonnenen Signals (FB) innerhalb des vorbestimmten Zeitfensters vor der entsprechenden Taktflanke (A) des Taktsignals (CLK) oder des hieraus gewonnenen Signals liegt, von der Einrichtung (5) ein Ermittlungs-Signal (SLOW) an die Verzögerungseinrichtung (2) gesendet wird.

3. Vorrichtung (1) nach einem der Ansprüche 1 oder 2, welche eine Einrichtung (29b, 19b) aufweist zum Halten der Verzögerungseinrichtung (2) in einem Modus, bei welchem die von der Verzögerungseinrichtung (2) bewirkte Signal-Verzögerungszeit (tᵥₐᵣ) in den kleineren Zeitschritten verringert oder erhöht wird, nachdem ermittelt wurde, dass die Taktflanke (A') des von der Verzögerungseinrichtung (2) ausgegebenen verzögerten Taktsignals (DQS) oder des hieraus gewonnenen Signals (FB) innerhalb des vorbestimmten Zeitfensters vor der entsprechenden Taktflanke (A) des Taktsignals (CLK) oder des hieraus gewonnenen Signals liegt.

4. Taktsignal-Synchronisationsverfahren, welches den Schritt aufweist:
- Beaufschlagen eines Taktsignals (CLK) oder eines hieraus gewonnenen Signals mit einer variabel steuerbaren, in variabel steuerbaren Zeitschritten verringerbaren oder erhöhbaren Verzögerungszeit (tᵥₐᵣ), so dass ein verzögertes Taktsignal (DQS) gewonnen wird,
wobei das Verfahren zusätzlich den Schritt aufweist:
- Ermitteln, ob eine Taktflanke (A') des verzögerten Taktsignals (DQS) oder eines hieraus gewonnenen Signals (FB) innerhalb eines vorbestimmten Zeitfensters vor einer entsprechenden Taktflanke (A) des Taktsignals (CLK) oder des hieraus gewonnenen Signals liegt, wobei dann, wenn ermittelt wird, dass die Taktflanke (A') des verzögerten Taktsignals (DQS) oder des hieraus gewonnenen Signals (FB) innerhalb des vorbestimmten Zeitfensters vor der entsprechenden Taktflanke (A) des Taktsignals (CLK) oder des hieraus gewonnenen Signals liegt, die Signal-Verzögerungszeit (tᵥₐᵣ) in kleineren Zeitschritten, und damit langsamer verringert oder erhöht wird, als vor der Ermittlung,
**dadurch gekennzeichnet, dass** die Zeitdauer (Δt) des Zeitfensters abhängig von der von einer Frequenz-Ermittlungs-Einrichtung ermittelten Frequenz des Taktsignals (CLK) durch automatisches Umschalten einer Verzögerungs-Einrichtung (13) durch die Frequenz-Ermittlungs-Einrichtung gewählt wird.

## Claims

1. A device (1) for utilization with the synchronization of clock signals (CLK), comprising delay means (2) with a variably controllable delay time (tᵥₐᵣ) that can be decremented or incremented in variably controllable time steps, into which a clock signal (CLK), or a signal obtained therefrom, is input, is charged with the variably controllable delay time (tᵥₐᵣ) that can be decremented or incremented in variably controllable time steps, and is output as a delayed clock signal (DQS), wherein additionally means (5) is provided for determining whether a clock edge (A') of the delayed clock signal (DQS) output by the delay means (2), or of a signal (FB) obtained therefrom, lies within a predetermined time window before a corresponding clock edge (A) of the clock signal (CLK), or of the signal obtained therefrom,
and wherein said device (1) is designed and equipped such that, if said means (5) determines that the clock edge (A') of the delayed clock signal (DQS) output by said delay means (2), or of the signal (FB) obtained therefrom, lies within the predetermined time window before the corresponding clock edge (A) of the clock signal (CLK), or of the signal obtained therefrom, the signal delay time (tᵥₐᵣ) caused by said delay means (2) is decremented or incremented in smaller time steps, and thus more slowly, than prior to the determination,
**characterized in that**
the duration (Δt) of the time window is chosen as a function of the frequency of the clock signal (CLK) determined by a frequency determination means by the automatic switching of a delay means (13) by the frequency determination means.

2. The device (1) according to claim 1, which is designed and equipped such that, if it is determined that the clock edge (A') of the delayed clock signal (DQS) output by said delay means (2), or of the signal (FB) obtained therefrom, lies within the predetermined time window before the corresponding clock edge (A) of the clock signal (CLK), or of the signal obtained therefrom, said means (5) sends a determination signal (SLOW) to said delay means (2).

3. The device (1) according to any of claims 1 or 2, comprising means (29b, 19b) for keeping said delay means (2) in a mode in which the signal delay time (tᵥₐᵣ) caused by said delay means (2) is decremented or incremented in said smaller time steps after it has been determined that the clock edge (A') of the delayed clock signal (DQS) output by said delay means (2), or of the signal (FB) obtained therefrom, lies within the predetermined time window before the corresponding clock edge (A) of the clock signal (CLK), or of the signal obtained therefrom.

4. A clock signal synchronizing method, comprising the step of:
- charging a clock signal (CLK) or a signal obtained therefrom with a variably controllable delay time (tᵥₐᵣ) that can be decremented or incremented in variably controllable time steps, so that a delayed clock signal (DQS) is obtained,
wherein the method additionally comprises the step of:
- determining whether a clock edge (A') of the delayed clock signal (DQS), or of a signal (FB) obtained therefrom, lies within a predetermined time window before a corresponding clock edge (A) of the clock signal (CLK), or of the signal obtained therefrom, wherein, if it is determined that the clock edge (A') of the delayed clock signal (DQS) or of the signal (FB) obtained therefrom, lies within the predetermined time window before the corresponding clock edge (A) of the clock signal (CLK), or of the signal obtained therefrom, the signal delay time (tᵥₐᵣ) is decremented or incremented in smaller time steps, and thus more slowly, than prior to the determination,
**characterized in that**
the duration (Δt) of the time window is chosen as a function of the frequency of the clock signal (CLK) determined by a frequency determination means by the automatic switching of a delay means (13) by the frequency determination means.

## Revendications

1. Dispositif (1) utilisé pour la synchronisation de signaux de rythme (CLK), comprenant un dispositif de temporisation (2) avec un temps de temporisation (tᵥₐᵣ) pouvant être commandé de façon variable et pouvant être réduit ou augmenté dans des incréments de temps contrôlables de façon variable, dans lequel un signal de rythme (CLK) ou un signal obtenu à partir de celui-ci est entré, est alimenté avec le temps de temporisation (tᵥₐᵣ) qui peut être commandé de façon variable et réduit ou augmenté dans des incréments de temps contrôlables de façon variable, et est édité sous la forme de signal de rythme (DQS) temporisé,
un dispositif (5) étant prévu en supplément pour déterminer si un flanc de rythme (A') du signal de rythme (DQS) temporisé, édité par le dispositif de temporisation (2), ou d'un signal (FB) obtenu à partir de celui-ci est disposé à l'intérieur d'une fenêtre de temps prédéfinie avant un flanc de rythme (A) correspondant du signal de rythme (CLK) ou du signal obtenu à partir de celui-ci,
et le dispositif (1) étant conçu et aménagé de telle sorte que, dans les cas où le dispositif (5) détermine que le flanc de rythme (A') du signal de rythme (DQS) temporisé et édité par le dispositif de temporisation (2), ou du signal (FB) obtenu à partir de celui-ci est situé à l'intérieur de la fenêtre de temps prédéfinie avant le flanc de rythme (A) correspondant du signal de rythme (CLK) ou du signal obtenu à partir de celui-ci, le temps de temporisation de signal (tᵥₐᵣ) provoqué par le dispositif de temporisation (2) est réduit ou augmenté par des incréments de temps plus petits, et donc plus lentement qu'avant la détermination,
**caractérisé en ce que** la durée (Δt) de la fenêtre de temps est choisie en fonction de la fréquence déterminée par un dispositif de calcul de fréquence, du signal de rythme (CLK) par commutation automatique d'un dispositif de temporisation (13) par le dispositif de calcul de fréquence.

2. Dispositif (1) selon la revendication 1, qui est conçu et aménagé de telle sorte que, lorsqu'on détermine que le flanc de rythme (A') du signal de rythme (DQS) temporisé et édité par le dispositif de temporisation (2) ou du signal (FB) obtenu à partir de celui-ci se situe à l'intérieur de la fenêtre de temps prédéfini avant le flanc de rythme (A) correspondant du signal de rythme (CLK) ou du signal obtenu à partir de celui-ci, le dispositif (5) envoie un signal de calcul (SLOW) au dispositif de temporisation (2).

3. Dispositif (1) selon l'une quelconque des revendications 1 ou 2, qui présente un dispositif (29b, 19b) pour maintenir le dispositif de temporisation (2) dans un mode dans lequel le temps de temporisation de signal (tᵥₐᵣ) provoqué par le dispositif de temporisation (2) est réduit ou augmenté dans les incréments de temps plus petits, après avoir déterminé que le flanc de rythme (A') du signal de rythme (DQS) temporisé et édité par le dispositif de temporisation (2), ou du signal (FB) obtenu à partir de celui-ci se situe à l'intérieur de la fenêtre de temps prédéfinie avant le flanc de signal (A) correspondant du signal de rythme (CLK) ou du signal obtenu à partir de celui-ci.

4. Procédé de synchronisation de signal de rythme, qui présente l'étape suivante :
- alimentation d'un signal de rythme (CLK) ou d'un signal obtenu à partir de celui-ci avec un temps de temporisation (tᵥₐᵣ) pouvant être contrôlé de façon variable et pouvant être réduit ou augmenté dans des incréments de temps contrôlables de façon variable, de sorte qu'on obtient un signal de rythme (DQS) temporisé,
le procédé présentant en supplément l'étape suivante :
- déterminer si un flanc de rythme (A') du signal de rythme (DQS) temporisé ou d'un signal (FB) obtenu à partir de celui-ci peut se situer à l'intérieur d'une fenêtre de temps prédéfinie avant un flanc de rythme (A) correspondant du signal de rythme (CLK) ou du signal obtenu à partir de celui-ci, sachant que, lorsqu'on détermine que le flanc de rythme (A') du signal de rythme (DQS) temporisé ou du signal (FB) obtenu à partir de celui-ci se situe à l'intérieur de la fenêtre de temps prédéfinie avant le flanc de rythme (A) correspondant du signal de rythme (CLK) ou du signal obtenu à partir de celui-ci, le temps de temporisation de signal (tᵥₐᵣ) est réduit ou augmenté dans des incréments de temps plus petits, et donc plus lentement qu'avant la détermination,
**caractérisé en ce que** la durée (Δt) de la fenêtre de temps est choisie en fonction de la fréquence, déterminée par le dispositif de calcul de fréquence, du signal de rythme (CLK) par commutation automatique d'un dispositif de temporisation (13) par le dispositif de calcul de fréquence.
